# EUROPEAN PATENT SPECIFICATION

(11) **EP 2 113 310 B1**
(45) Date of publication and mention of the grant of the patent: **02.09.2015**
(21) Application number: 09005952.8
(22) Date of filing: 29.04.2009
(51) Int. Cl.: B05D 7/24, C23C 14/54, C23C 14/56

(54) **Film depositing apparatus**
Filmabscheidungsvorrichtung
Appareil de dépôt de film

(30) Priority: 02.05.2008 JP 2008120211
(43) Date of publication of application: 04.11.2009
(73) Proprietor: FUJIFILM Corporation, Minato-ku Tokyo (JP)
(72) Inventor: Fujinami, Tatsuya, Odawara-shi Kanagawa (JP); Nishida, Hiroyuki, Odawara-shi Kanagawa (JP); Kadota, Norihiro, Odawara-shi Kanagawa (JP)
(74) Representative: Hoffmann Eitle

(56) References cited:
- EP-A- 2 085 496
- EP-A- 2 085 497
- WO-A-00/62943
- US-A- 4 842 893
- US-A- 4 954 371

## Description

### TECHNICAL FIELD

The present invention is directed to a film depositing apparatus by which an organic layer can be formed on a surface of an elongated substrate as it is transported along a predetermined transport path in a longitudinal direction and then an inorganic layer can be formed on top of the organic layer.

### BACKGROUND OF THE INVENTION

Current models of various apparatuses including display apparatuses (e.g., liquid-crystal displays and organic EL displays), optical devices, semiconductor apparatuses and thin-film solar batteries utilize a variety of functional films (functional sheets) including gas barrier films, protective films, optical filters, and optical films such as anti-reflective films.

These functional films are manufactured by depositing films (forming thin films) through vacuum film deposition techniques (vapor-phase film deposition techniques) such as sputtering and plasma-assisted CVD.

To deposit films by vacuum film deposition techniques while assuring high efficiency and productivity, it is preferred to perform continuous film deposition on an elongated substrate.

While various types of apparatus are known to be capable of such continuous film deposition, an exemplary system is of a roll-to-roll type which uses a supply roll consisting of a roll of elongated substrate (a substrate in web form) and a takeup roll consisting of a roll of the substrate on which a film has been deposited. In this type of film depositing apparatus, the elongated substrate is passed from the supply roll to the takeup roll along a predetermined path through a film deposition compartment in which a film is deposited continuously on the substrate by plasma-assisted CVD as the latter is delivered from the supply roll in synchronism with the takeup of the substrate by the takeup roll after the film has been deposited on it.

Functional films such as gas barrier films and protective films are not necessarily single-layered and a dual functional film is also known that consists of a substrate such as a plastic film, a polymer-based organic layer formed on it, and an inorganic layer made of an inorganic material and deposited on top of the organic layer. A film depositing apparatus capable of producing functional films of this construction has already been proposed (see the official gazette of JP 2007-230115 A).

JP 2007-230115 A discloses an apparatus for producing a transparent film of gas barrier quality that uses one and the same vacuum chamber to form a thin organic layer of gas barrier quality and a thin inorganic layer of gas barrier quality on one or both sides of a film of transparent substrate.

The apparatus of JP 2007-230115 A for producing a transparent film of gas barrier quality is so designed that one and the same vacuum chamber contains two takeup rolls, between which a film of transparent substrate is stretched over a main roll and two auxiliary rolls that are interposed in the transport path.

Provided in a predetermined position on the outer periphery of the main roll is a coating unit for applying a vaporized organic material, which is connected to a vacuum pump outside of the vacuum chamber via a vacuum drawing pipe. The vacuum drawing pipe and the vacuum pump combine to create a lower pressure than in the vacuum chamber. An ultraviolet ray lamp unit is provided in a corresponding position between the main roll and the auxiliary roll that is closer to the takeup roll. An electron beam generator is provided as an inorganic material evaporation source in the bottom of the vacuum chamber. A hearth is provided on top of the electron beam generator. Provided separate from the electron beam generator is a plasma gun with a pressure gradient.

In JP 2007-230115 A , the thin organic layer of gas barrier quality is formed in the following manner: a material capable of forming the thin organic layer of gas barrier quality is evaporated to generate its vapor, which is brought into contact with the film of transparent substrate under an ambient pressure condition lower than the pressure within the vacuum chamber to form a coating, which is hardened by the ultraviolet ray lamp to form the thin transparent organic layer of gas barrier quality.

In the process of forming a coating within the vacuum chamber, the vapor is brought into contact with the film of transparent substrate under an ambient pressure condition lower than the pressure within the vacuum chamber. The ambient pressure condition lower than the pressure within the vacuum chamber can be realized by means of a vacuum pump that is separate from the one provided for drawing vacuum from within the vacuum chamber.

The thin inorganic layer of gas barrier quality is formed in the following manner: a material capable of forming the thin inorganic layer of gas barrier quality is irradiated with an electron beam and the evaporated material is activated by means of a plasma generated by the plasma gun with a pressure gradient to thereby form the thin inorganic layer of gas barrier quality on top of the thin organic layer of gas barrier quality on the film of transparent substrate.

A problem with the apparatus of JP 2007-230115 A is that even if the thin organic layer of gas barrier quality is formed under an ambient pressure condition lower than the pressure within the vacuum chamber, the vapor generated by evaporating the material capable of forming that thin organic layer will get into the region of the main roll where the thin inorganic layer of gas barrier quality is to be formed, thereby contaminating that region. A similar problem occurs in the process of forming the thin inorganic layer of gas barrier quality; the material that has been evaporated by the electron beam with a view to forming the thin inorganic layer of gas barrier quality will get into the coating unit for applying the vaporized organic material, thereby contaminating the coating unit. Thus, the apparatus of JP 2007-230115 A which is adapted to form both the thin organic and inorganic layers within the same vacuum chamber is subject to contamination in both processes of forming the thin organic and inorganic layers and this potentially degrades the quality of the film as the final product.

Yet another problem with the apparatus of JP 2007-230115 A is that both the thin organic and inorganic layers are formed on a single drum (main roll). As the result, if the optimum temperature for film deposition differs between the thin organic and inorganic layers, the quality of either the thin organic or inorganic layer or both layers will deteriorate.

As a further problem, if a vapor-phase film deposition technique such as sputtering or plasma-assisted CVD is employed to form the thin inorganic layer, the speed at which the film of substrate is transported needs to be adjusted to equal the relatively slow film deposition rate. This means if one wants to increase the transport speed of the film of substrate, it is necessary that the film deposition zone where the thin inorganic layer is to be formed should be made longer in the direction in which the drum rotates. However, the thin organic layer is formed over the same drum as the thin inorganic layer and this puts a restraint on the attempt to increase the length of the zone where the thin inorganic layer is to be formed. Thus, with the apparatus of JP 2007-230115 A, the transport speed of the film of substrate cannot be made fast enough to increase the production rate.

Reference is also made to EP 2 085 496 A1, which discloses a method for producing a functional film, and

US 4,954,371 A1, which discloses a method for continuously supplying a uniform vapor of a polymerizable material. EP 2 085 496 A1 is considered to disclose a combination of features falling within the scope of the preamble of claim 1.

### SUMMARY OF THE INVENTION

A film depositing apparatus by which an organic layer can be formed on a surface of an elongated substrate as it is transported along a predetermined transport path in a longitudinal direction and then an inorganic layer can be formed on top of the organic layer, the film depositing apparatus comprising:
a transport means for transporting the substrate along the predetermined transport path;
a first film deposition compartment that is provided with a first film depositing means for forming the organic layer on the surface of the substrate; and
a second film deposition compartment that is disposed downstream of the first film deposition compartment in the transport path and which is provided with a second film depositing means for forming an inorganic layer on top of the organic layer, characterized by:
   a supply compartment for supplying the elongated substrate;
   a take-up compartment for winding up the elongated substrate;
   a differential pressure compartment disposed in the transport path between the first film deposition compartment and the second film deposition compartment,; and an evacuating unit that is arranged to reduce the pressures within the first film deposition compartment, the second film deposition compartment, the supply compartment, the take-up compartment and the differential pressure compartment, wherein:
      the transport means is arranged such that the substrate is transported through the first film deposition compartment, the differential pressure compartment and the second film deposition compartment in that order.

With embodiments of the present invention it is possible to solve the aforementioned problems of the prior art and provide an apparatus with which an organic and an inorganic layer of satisfactory film quality can be deposited with high production efficiency.

### BRIEF DESCRIPTION OF THE DRAWINGS

In order to enable a better understanding of the present invention and to show how the same may be carried into effect, reference will now be made, by way of example only, to the accompanying drawings, in which:
FIG. 1 is a schematic diagram showing a film depositing apparatus according to a first embodiment that does not include a differential pressure compartment.
FIG. 2 is a schematic diagram showing a film depositing apparatus according to a second embodiment of the present invention.

### DETAILED DESCRIPTION OF THE INVENTION

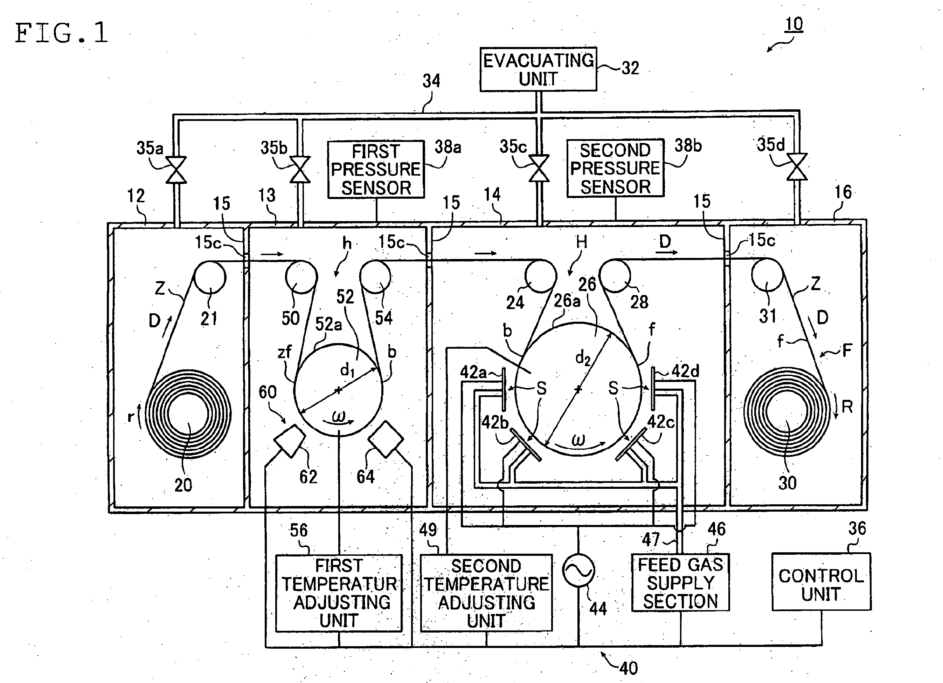

FIG. 1 is a schematic diagram showing a film depositing apparatus 10 according to a first embodiment.

The film depositing apparatus 10 is a roll-to-roll type machine capable of continuously depositing a film on an elongated substrate Z (a web of substrate Z); as the substrate Z is transported in vacuum along a predetermined transport path in its longitudinal direction, an organic layer b is formed on a surface Zf of the substrate Z and, consequently, an inorganic layer f having a specified function is formed on a surface of the organic layer b. The film depositing apparatus 10 is typically employed to produce a functional film F such as an optical film or a gas barrier film.

The film depositing apparatus 10 comprises basically a supply compartment 12 for supplying the elongated substrate Z, an organic layer depositing compartment (a first film deposition compartment) 13 for forming an organic layer b on the surface Zf of the elongated substrate Z, an inorganic layer depositing compartment (a second film deposition compartment) 14 for forming an inorganic layer f on top of the organic layer b, a takeup compartment 16 for winding up the elongated substrate Z after the inorganic layer f has been formed on it, an evacuating unit (an evacuating means) 32, and a control unit 36. The control unit 36 controls the actions of the individual elements of the film depositing apparatus 10.

In the film depositing apparatus 10, the supply compartment 12 and the organic layer depositing compartment 13 are partitioned by a wall 15, the organic layer depositing compartment 13 and the inorganic layer depositing compartment 14 by a wall 15, and the inorganic layer depositing compartment 14 and the takeup compartment 16 by a wall 15; a slit of opening 15c through which the substrate Z can pass is formed in each of the walls 15.

In the film depositing apparatus 10, each of the supply compartment 12, the organic layer depositing compartment 13, the inorganic layer depositing compartment 14 and the takeup compartment 16 is connected to the evacuating unit 32 via a piping system 34. The evacuating unit 32 evacuates the interiors of the feed compartment 12, the organic layer depositing compartment 13, the inorganic layer depositing compartment 14 and the takeup compartment 16 to generate specified pressures. Thus, the evacuating unit 32 creates specified degrees of vacuum in the interiors of those compartments.

The part of the piping system 34 that connects to the supply compartment 12 is fitted with a first valve 35a; the part that connects to the organic layer depositing compartment 13 is fitted with a second valve 35b; the part that connects to the inorganic layer depositing compartment 14 is fitted with a third valve 35c; and the part that connects to the takeup compartment 16 is fitted with a fourth valve 35d.

Each of the first valve 35a, the second valve 35b, the third valve 35c and the fourth valve 35d typically has such functions as for releasing the pressure to the atmosphere (venting) and adjusting the volume of evacuation through an orifice or the like; the first valve 35a, the second valve 35b, the third valve 35c and the fourth valve 35d are each connected to the control unit 36 which controls the pressure release to the atmosphere (venting) and the adjustment of the volume to be evacuated.

Note that neither of the first valve 35a, the second valve 35b, the third valve 35c and the fourth valve 35d need be composed of a single valve and, instead, they may individually be composed of two valves, one capable of releasing the pressure to the atmosphere (venting) and the other for adjusting the volume of evacuation.

To evacuate the interiors of the supply compartment 12, the organic layer depositing compartment 13, the inorganic layer depositing compartment 14 and the takeup compartment 16 to reduce their internal pressures to specified levels and maintain the lower pressures (the specified degrees of vacuum), the evacuating unit 32 has vacuum pumps such as a dry pump and a turbo-molecular pump.

The organic layer depositing compartment 13 is equipped with a first pressure sensor 38a for measuring its internal pressure, and the inorganic layer depositing compartment 14 is equipped with a second pressure sensor 38b for measuring its internal pressure. Although not shown, the supply compartment 12 and the takeup compartment 16 are also equipped with a pressure sensor for measuring their internal pressure.

The first pressure sensor 38a, the second pressure sensor 38b, and the other pressure sensors (not shown) may be of any known types that can measure the pressure within vacuum chambers.

Note that the ultimate degree of vacuum that should be created in the supply compartment 12, the organic layer depositing compartment 13, the inorganic layer depositing compartment 14 and the takeup compartment 16 by the evacuating unit 32 is not particularly limited and an adequate pressure (degree of vacuum) suffices to be maintained in accordance with such factors as the method of film deposition to be implemented. The evacuating unit 32 is controlled by the control unit 36.

The supply compartment 12 is a site for supplying the elongated substrate Z, where a substrate roll 20 and a guide roller 21 are provided.

The substrate roll 20 is for delivering the elongated substrate Z continuously.

The substrate roll 20 is typically connected to a motor (not shown) as a drive source. By means of this motor, the substrate roll 20 is rotated in a direction r in which the subsltrate Z is rewound; in the first embodiment shows in FIG. 1, the substrate roll 20 is rotated clockwise to deliver the substrate Z continuously.

The guide roller 21 is for guiding the substrate Z into the organic layer depositing compartment 13 in a predetermined transport path. The guide roller 21 is composed of a known guide roller.

In the film depositing apparatus 10 of the first embodiment under consideration, the guide roller 21 may be a drive roller or a follower roller. Alternatively, the guide roller 21 may be a roller that works as a tension roller that adjusts the tension that develops during the transport of the substrate Z.

Note that in the film depositing apparatus of the present invention, the substrate Z is not particularly limited and all kinds of substrates can be employed as long as they enable films to be formed by vapor-phase film deposition techniques. Usable as the substrate Z are various resin films such as a PET film and a PEN film, or various metal sheets such as an aluminum sheet.

As will be described later, the takeup compartment 16 is a site where the substrate Z with an inorganic layer f having been formed on top of the organic layer b in the inorganic layer depositing compartment 14 (to make a functional film F) is wound up; in this takeup compartment 16, there are provided a takeup roll 30 and a guide roller 31.

The takeup roll 30 is a device by which the substrate Z with an inorganic layer f having been formed on top of the organic layer b (to make a function film F) is wound up in a roll, typically clockwise.

The takeup roll 30 is typically connected to a motor (not shown) as a drive source. By means of this motor, the takeup roll 30 is rotated to wind up the substrate Z with an inorganic layer f having been formed on top of the organic layer b (to make a function film F).

By means of the motor, the takeup roll 30 is rotated in a direction R in which the substrate Z is wound up; in the first embodiment shown in FIG. 1, the takeup roll 30 is rotated clockwise, whereupon the substrate Z with an inorganic layer f having been formed on top of the organic layer b (to make a function film F) is wound up continuously, typically clockwise.

The guide roller 31 is similar in construction to the aforementioned guide roller 21 and the substrate Z being transported from the inorganic layer depositing compartment 14 is guided by this roller to the takeup roll 30 in a predetermined transport path. The guide roller 31 is composed of a known guide roller. Note that like the guide roller 21 in the supply compartment 12, the guide roller 31 may be a drive roller or a follower roller. Alternatively, the guide roller 31 may be a roller that works as a tension roller.

The organic layer depositing compartment 13 is a site where a polymer-based organic layer b is formed on the surface Zf of the substrate Z at a predetermined internal pressure, namely, with the degree of vacuum being maintained at a predetermined level, in a continuous manner as the substrate Z is being transported, typically by flash evaporation (as will be described later).

In the organic layer depositing compartment 13, there are provided two guide rollers 50 and 54, as well as a cylindrical first drum 52 and an organic layer depositing unit 60.

The guide rollers 50 and 54 are spaced apart parallel to each other in a face-to-face relationship; they are also provided in such a way that their longitudinal axes cross at right angles to a direction D in which the substrate Z is transported.

The guide roller 50 is a device by which the substrate Z transported from the guide roller 21 provided in the supply compartment 12 is transported to the first drum 52. The guide roller 50 is rotatable, typically having an axis of rotation in a direction perpendicular to the transport direction D of the substrate Z (this direction is hereinafter referred to as the axial direction), and its length in the axial direction is greater than the length in a width direction that is perpendicular to the longitudinal direction of the substrate Z (the latter length is hereinafter referred to as the width of the substrate Z).

The guide roller 54 is a device by which the substrate Z wrapped around the first drum 52 is transported to the guide roller 24 provided in the inorganic layer depositing compartment 14.

The guide roller 54 is rotatable, typically having an axis of rotation in the axial direction, and its length in the axial direction is greater than the width of the substrate Z.

Except for the features just described above, the guide rollers 50 and 54 have the same structure as the guide roller 21 provided in the supply compartment 12, so they will not be described in detail.

The first drum 52 is provided below the space h between the guide rollers 50 and 54. The first drum 52 is so positioned that its longitudinal axis is parallel to those of the guide rollers 50 and 54.

The first drum 52 typically assumes a cylindrical shape, has a rotational axis (not shown), and is capable of rotating about this rotational axis in the direction of rotation ω. Also note that the length of the first drum 52 in the axial direction is greater than the width of the substrate Z. The first drum 52, as it rotates in the direction of rotation ω with the substrate Z wrapped around its surface 52a (peripheral surface), transports the substrate Z in the transport direction D while it is kept in registry with a predetermined film depositing position.

It should be noted here that the side to the direction of travel parallel to the direction of rotation ω of the first drum 52, namely, the side to which the substrate Z is transported is the downstream side, and the side opposite to this downstream side is the upstream side.

For temperature adjustment, the first drum 52 is provided, typically in its center, with a heater (not shown) and a temperature sensor (also now shown) that measures the temperature of the first drum 52.

A piping system (not shown) for circulating a coolant is provided in the interior of the first drum 52, which is also provided with a pump (not shown) to circulate the coolant. The piping system, the coolant and the pump combine to constitute the cooling means.

The heater, the pump and the temperature sensor are connected to a first temperature adjusting unit 56. The first temperature adjusting unit 56 is connected to the control unit 36 which controls the first temperature adjusting unit 56 to adjust the temperature of the first drum 52 such that it is held at a predetermined temperature. The heater (not shown), the cooling means, the temperature sensor (not shown) and the first temperature adjusting unit 56 combine to constitute the temperature adjusting means.

It is by this temperature adjusting means that the first drum 52 is cooled to a temperature as appropriate for various factors such as the composition of the organic layer b to be formed. This contributes to making an organic layer b of an even better quality.

The organic layer depositing unit 60 is a site where an organic layer b is deposited by flash evaporation on the surface Zf of the substrate Z as it is wrapped around the first drum 52; this unit has a monomer nozzle 62 and a UV irradiator 64. The monomer nozzle 62 and the UV irradiator 64 are spaced apart and provided in a face-to-face relation with the surface 52a of the first drum 52 along the direction of rotation ω of the first drum 52 in such a way that the monomer nozzle 62 is on the upstream side and the UV irradiator 64 on the downstream side.

Flash evaporation to be performed in the first embodiment under consideration is particularly useful because it can sufficiently lower the level of dissolved oxygen in the monomer to increase the percent polymerization.

In the process of forming the organic layer b, the pressure in the organic layer depositing compartment 13 is reduced to a specified level by the evacuating means 32. In addition, the first drum 52 is cooled to a predetermined temperature by the first temperature adjusting unit 56.

At the reduced pressure, a preconditioned coating liquid containing one or more of the monomers listed below is applied through the monomer nozzle 62 to the surface Zf of the substrate Z. As the result, a coating is deposited by flash evaporation on the surface Zf of the substrate Z.

The UV irradiator 64 is a device by which the flash evaporated coating is irradiated with UV light (ultraviolet rays) so that the monomer is polymerized to deposit an organic layer b.

The light sources that can be used and the irradiation energy to be applied are as described later. The method of polymerizing monomers is not limited to the UV irradiation employed in the first embodiment under consideration and various other methods may be adopted.

In the first embodiment under consideration, the organic layer b is deposited with the first drum 52 kept cooled and this contributes to providing a uniform film thickness.

It should also be mentioned that in the first embodiment under consideration, the method of depositing the organic layer b is in no way limited to flash evaporation as long as it is capable of forming the organic layer in vacuum.

The organic layer b is a polymer-based film.

Polymers that can be used to form the organic layer b are specifically exemplified by thermoplastic resins such as polyesters, acrylic resins and methacrylic resins (the two kinds of resins are hereinafter sometimes collectively referred to as polymerized acrylates), methacrylic acid-maleic acid copolymers, polystyrenes, transparent fluroresins, polylimides, fluorinated polyimides, polyamides, polyamideimide, polyetherimide, cellulose acylate, polyurethane, polyetheretherketone, polycarbonate, alicyclic polyolefins, polyallyate, polyethersulfone, polylsulfones, fluorene cyclic modified polycarbonates, alicyclic modified polycarbonates, fluorene cyclic modified polyesters, and acryloyl compounds; films of polysiloxanes and other organosilicon compounds may also be used.

The organic layer b may be composed of individual materials or mixtures thereof. If desired, the organic layer b may consist of two or organic sub-layers in superposition; in this case, the respective sub-layers may be of the same or different compositions. Alternatively, as disclosed in the specification of US 2004/0046497 A1, the organic layer b may not have distinct interfaces with the inorganic layer f but provides a composition that changes continuously in a direction of its thickness.

The organic layer b is preferably smooth with high film hardness. The smoothness of the organic layer b is preferably such that it is 10 nm or less, more preferably 2 nm or less, in terms of the average roughness (Ra) per 10 µm square.

The organic layer b preferably has a film hardness in excess of a certain value. A preferred hardness is 100 N/mm² or above in terms of indentation hardness as measured by the nano-indentation method, with 200 N/mm² or above being more preferred. A preferred pencil hardness is HB or above, more preferably H or above.

The thickness of the organic layer b is not particularly limited; however, if it is unduly thin, it is difficult to obtain a uniform film, and if it is unduly thick, an external force may cause cracking which, in turn, degrades the barrier performance. From these viewpoints, the thickness of the organic layer b is preferably between 10 nm and 2 µm, more preferably between 100 nm and 1 µm.

Note that the method of forming the organic layer b is not particularly limited and vacuum film depositing techniques may also be employed.

While the vacuum film depositing techniques that can be employed are not particularly limited, evaporation, plasma-assisted CVD and other similar film depositing approaches are preferred. Speaking of flash evaporation, the methods described in the specifications of US Patents 4,842,893, 4,954,371, and 5,032,461 are particularly preferred.

In the present invention, the organic layer b may also be formed by applying a polymer in solution; alternatively, a hybrid coating method may be adopted using a coating solution containing one or more inorganic substances disclosed in the official gazettes of JP 2000-323273 A and JP 2004-25732 A.

Yet another method that may be employed to form the organic layer b is by forming a polymer layer such that a film of a polymer precursor, say, a monomer is first deposited and then the deposited film is polymerized.

Preferred monomers that can be used to form the organic layer b in the present invention include acrylates and methacrylates, as well as commercial adhesives. To be more specific, in the present invention, the organic layer b is preferably based on polymers obtained by polymerizing acrylate monomers and/or methacrylate monomers having ethylenically unsaturated bonds. In particular, in the case of using acrylate monomers and/or methacrylate monomers for certain reasons such as the possibility to avoid any inconveniences that might occur in vacuum (see below), it is preferred to use those monomers which have molecular weights of no more than 700, with those between 150 and 600 being particularly preferred.

Commercial adhesives include those of XNR-5000 Series manufactured by Nagase Chemtex Corporation.

Preferred examples of acrylate and methacrylate monomers include the compounds described in the specifications of US Patents 6,083,628 and 6,214,422.

While the methods of polymerizing monomers are not particularly limited, thermal polymerization, photopolymerization (under exposure to ultraviolet radiation or visible rays), electron-beam polymerization, plasma polymerization, or combinations thereof are preferably employed. If thermal polymerization is to be performed, the substrate Z must have sufficient heat resistance to withstand heating. In this case, it is at least necessary that the glass transition temperature (Tg) of the substrate Z should be higher than the heating temperature.

If photopolymerization is to be performed, a photopolymerization initiator is preferably used. Exemplary photopolymerization initiators include the following products marketed by Ciba Specialty Chemicals Inc., i.e., Irgacure Series (e.g. Irgacure 651, Irgacure 754, Irgacure 184, Irgacure 2959, Irgacure 907, Irgacure 369, Irgacure 379, and Irgacure 819), Darocure Series (e.g. Darocure TPO and Darocure 1173), Quantacure PDO, as well as the following products marketed by Sartomer Company, i.e., Ezacure Series (e.g. Ezacure TZM and Ezacure TZT) and Ezacure KIP Series of the oligomer type.

The light to be applied by the UV irradiator 64 is usually the ultraviolet radiation emitted by a high- or low-pressure mercury lamp. The irradiation energy is preferably 0.5 J/cm² or above, and more preferably 2 J/cm² or above.

It should be noted here that acrylate and methacrylate monomers are subject to hindered polymerization due to oxygen in the air. Hence, if acrylate or methacrylate monomers are used to form the organic layer b, it is preferred to keep the oxygen concentration or oxygen partial pressure low enough during polymerization. If nitrogen substitution is performed to lower the oxygen concentration during polymerization, the target oxygen concentration is preferably 2% or less, more preferably 0.5% or less. If evacuation is performed to lower the oxygen partial pressure during polymerization, the total pressure is preferably 1000 Pa or less, more preferably 100 Pa or less. It is particularly preferred to perform photopolymerization with UV radiation by applying an energy of 2 J/cm² or more at a reduced pressure of 100 Pa or less.

In the present invention, the percent polymerization of monomers is preferably at least 80%, more preferably at least 85%, and even more preferably at least 90%. The term percent polymerization as used herein means how much of the polymerizable groups that exist in a monomer mixture (for example, acryloyl and methacryloyl groups if the monomer mixture is that of acrylate and methacrylate) have entered into reaction.

As already mentioned, in the case of depositing an organic layer b that is the product of polymerization of an acrylate- based monomer and/or a methacrylate-based monomer, it is preferred to keep the oxygen concentration low enough during polymerization.

It should also be noted here that the organic layer b is not limited to a single-layered structure but may consist of two or more sub-layers. In the latter case, the,respective organic sub-layers may have the same or different compositions. If the organic layer b is to be formed in two or more sub-layers, it is preferred that the respective organic sub-layers are so adjusted that they are within the preferred ranges described above.

The substrate Z on which the organic layer b has been deposited within the organic layer depositing compartment 13 is subsequently transported into the inorganic layer depositing compartment 14.

The inorganic layer depositing compartment 14 is a site where the organic layer b formed on the surface Zf of the substrate Z is processed by a vapor-phase film deposition technique such as plasma-enhanced CVD (see below) to form an inorganic layer f,continuously, as the substrate Z is being transported.

In the first embodiment, the organic layer depositing compartment 13 is provided as a separate entity from the inorganic layer depositing compartment 14. Each of the organic layer depositing compartment 13 and the inorganic layer depositing compartment 14 is typically composed of materials such as stainless steel, aluminum or aluminum alloys that are commonly employed in a variety of vacuum chambers.

In the inorganic layer depositing compartment 14, there are provided two guide rollers 24 and 28, as well as a second drum 26 and a film depositing unit 40.

The guide rollers 24 and 28 are spaced apart parallel to each other in a face-to-face relationship; they are also provided in such a way that their longitudinal axes cross at right angles to the direction D in which the substrate Z is transported.

The guide roller 24 is a device by which the substrate Z transported from the guide roller 21 provided in the supply compartment 12 is transported to the second drum 26. The guide roller 24 is rotatable, typically having an axis of rotation in the axial direction and its length in the axial direction is greater than the width of the substrate Z.

The guide roller 28 is a device by which the substrate Z wrapped around the second drum 26 is transported to the guide roller 31 provided in the takeup compartment 16. The guide roller 28 is rotatable, typically having an axis of rotation in the axial direction and its length in the axial direction is greater than the width of the substrate Z.

Except for the features just described above, the guide rollers 24 and 28 have the same structure as the guide roller 21 provided in the supply compartment 12, so they will not be described in detail.

The second drum 26 is provided below the space H between the guide rollers 24 and 28. The second drum 26 is so positioned that its longitudinal axis is parallel to those of the guide rollers 24 and 28. In addition, the second drum 26 is grounded (not shown).

The second drum 26 typically assumes a cylindrical shape, has a rotational axis (not shown), and is capable of rotating about this rotational axis in the direction of rotation ω. Also note that the length of the second drum 26 in the axial direction is greater than the width of the substrate Z. The second drum 26, as it rotates in the direction of rotation ω with the substrate Z wrapped around its surface 26a (peripheral surface), transports the substrate Z in the transport direction D while it is kept in registry with a predetermined film depositing position.

It should be noted here that the side to the direction of travel parallel to the direction of rotation ω of the second drum 26, namely, the side to which the substrate Z is transported is the downstream side, and the side opposite to this downstream side is the upstream side.

Also note that the substrate roll 20, guide rollers 21 and 50, the first drum 52, guide rollers 54 and 24, the second drum 26, guide rollers 28 and 31, and the takeup roll 30 combine to constitute the transport means of the present invention.

For temperature adjustment, the second drum 26 is provided, typically in its center, with a heater (not shown) and a temperature sensor (also now shown) that measures the temperature of the second drum 26.

A piping system (not shown) for circulating a coolant is provided in the interior of the second drum 26, which is also provided with a pump (not shown) to circulate the coolant. The piping system, the coolant and the pump combine to constitute the cooling means.

The heater, the pump and the temperature sensor are connected to a second temperature adjusting unit 49. The second temperature adjusting unit 49 is connected to the control unit 36 which controls the second temperature adjusting unit 49 to adjust the temperature of the second drum 26 such that it is held at a predetermined temperature. The heater (not shown), the cooling means, the temperature sensor (not shown) and the second temperature adjusting unit 49 combine to constitute the temperature adjusting means.

It is by this temperature adjusting means that the second drum 26 is cooled to a temperature as appropriate for various factors such as the composition of the inorganic layer f to be formed. This contributes to making an inorganic layer f of an even better quality.

It should also be noted that in the first embodiment under consideration, the first drum 52 in the organic layer depositing compartment 13 has a diameter d₁ which is smaller than the diameter d₂ of the second drum 26 in the inorganic layer depositing compartment 14.

The film depositing unit 40 shown in FIG. 1 is such that with the substrate Z being wrapped around the second drum 26, the latter rotates so that an inorganic layer f is formed on top of the organic layer b formed on the surface Zf of the substrate Z as it is transported in the transport direction D.

The film depositing unit 40 is a device to form a film, typically by a plasma-assisted CVD process which is one of the vapor-phase film depositing techniques. An example of the plasma enhanced CVD process is capacitively coupled plasma-assisted CVD (CCP-CVD).

The film depositing unit 40 has film depositing electrodes 42a to 42d, a radio-frequency power source 44, and a feed gas supply section 46. The control unit 36 controls the radio-frequency power source 44 and the feed gas supply section 46 in the film depositing unit 40.

In the film depositing unit 40, there are provided a plurality of film depositing electrodes 42a to 42d. Each of the film depositing electrodes 42a to 42d is typically made of a flat electrode plate which is rectangular as seen in a plan view; having a plurality of holes (not shown) formed at equal spacings in their major surfaces, those electrodes are each of a type that is generally called a shower head electrode.

The film depositing electrodes 42a to 42d are disposed along the direction of rotation ω as if to follow the surface 26a of the second drum 26, with their length being parallel to the rotational axis of the second drum 26 and with their major surfaces being oriented to the surface 26a of the second drum 26 at predetermined spaces S away from the surface 26a of the second drum 26. Typically, the four film depositing electrodes 42a to 42d are disposed to align with lines tangent to a circle concentric with the surface 26a of the second drum 26.

In the first embodiment under consideration, the film depositing electrodes 42a to 42d are preferably distant from the surface 26a of the second drum 26 by equal gaps at the spaces S, provided that the gap of one space S may vary from the gap of another space S but by a value not exceeding 20%.

Each of the film depositing electrodes 42a to 42d is connected to the radio-frequency power source 44, which applies a radio-frequency voltage to the film depositing electrode plates of which the respective film depositing electrodes 42a to 42d are formed. The radio-frequency power source 44 is capable of varying the radio-frequency power (RF power) to be applied.

Note that each of the film depositing electrodes 42a to 42d and the radio-frequency power source 44 may optionally be connected to each other via a matching box for impedance matching.

Note that the individual film depositing electrodes 42a to 42d may be adapted to conduct electrically to one another; in this case, electrical conduction may be established between the respective end portions of adjacent electrodes in a longitudinal direction. The positions at which electrical conduction is established between the respective film depositing electrodes 42a to 42d are not particularly limited as long as electrical conduction can be maintained.

The feed gas supply section 46 is typically such that a feed gas to form the inorganic layer f is supplied via a piping system 47 into the spaces S through the plurality of holes formed in the respective film depositing electrodes 42a to 42d. The space S between the surface 26a of the second drum 26 and each of the film depositing electrodes 42a to 42d serves as a space where plasma is to be generated.

In the first embodiment under consideration, if a SiO₂ film is to be formed as the inorganic layer f, the feed gas G is a TEOS gas, with oxygen gas being used as an active species gas. If a silicon nitride film is to be formed as the inorganic layer f, SiH4 gas, NH3 gas and N2 gas are used.

The feed gas supply section 46 may be chosen from a variety of gas introducing means that are employed in the CCP-CVD and other apparatuses.

Also note that the feed gas supply section 46 may supply into the spaces S not only the feed gas but also an inert gas such as argon or nitrogen gas, an active species gas such as oxygen gas, and various other gases that are used in CCP-CVD and other processes. In this case of introducing more than one species of gas, the respective gases may be mixed together in the same pipe and the mixture is passed through the plurality of holes in the film depositing electrodes 42a to 42d to be supplied into the spaces S; alternatively, the respective gases may be supplied through different pipes and thence passed through the plurality of holes in the film depositing electrodes 42a to 42d to be supplied into the spaces S.

The kinds of the feed gas, the inert gas and the active species gas, as well as the amounts in which they are introduced may be chosen and set as appropriate for various considerations including the kind of the film to be formed and the desired film deposition rate.

Note that the radio-frequency power source 44 may be of any known type that is employed in film deposition by plasma-assisted CVD. The maximum power output and other characteristics of the radio-frequency power source 44 are not particularly limited and may be chosen and set as appropriate for various considerations including the kind of the film to be formed and the desired film deposition rate.

We next describe how a film is deposited by the film depositing apparatus 10 according to the first embodiment.

In the predetermined path starting from the supply compartment 12 and passing through the organic layer depositing compartment 13 and the inorganic layer depositing compartment 14 to reach the takeup compartment 16, the elongated substrate Z is transported through the film depositing apparatus 10 from the supply compartment 12 down to the takeup compartment 16 such that the organic layer b is formed on the surface Zf of the substrate Z in the organic layer depositing compartment 13 and the inorganic layer f is formed on top of the organic layer b in the inorganic layer depositing compartment 14.

In the film depositing apparatus 10, the elongated substrate Z is unwound from the substrate roll 20 and transported into the organic layer depositing compartment 13 via the guide roller 21.

In the organic layer depositing compartment 13, the substrate Z passes over the guide roller 50, the first drum 52 and the guide roller 54 to be transported into the inorganic layer depositing compartment 14. In the meantime, the temperature adjusting means has cooled the first drum 52 to a temperature as appropriate for such factors as the composition of the organic layer b to be formed.

In inorganic layer depositing compartment 14, the substrate Z passes over the guide roller 24, the second drum 26 and the guide roller 28 to be transported into the takeup compartment 16. In the meantime, the temperature adjusting means has cooled the second drum 26 to a temperature as appropriate for such factors as the composition of the inorganic layer f to be formed.

In the takeup compartment 16, the elongated substrate Z passes over the guide roller 31 to be wound up by the takeup roll 30. After passing the elongated substrate Z through this transport path, the interiors of the supply compartment 12, the organic layer depositing compartment, the inorganic layer depositing compartment 14 and the takeup compartment 16 are evacuated by means of the evacuating unit 32 and a specified degree of vacuum (pressure) is maintained.

With the specified degree of vacuum being maintained in the organic layer depositing compartment 13, the monomer nozzle 62 in the organic layer forming unit 60 is used to form a coating by flash evaporation on the surface Zf of the substrate Z over the cooled first drum 52 and thereafter the coating is hardened by the UV irradiator 64 to form the organic layer b.

Subsequently, the substrate Z is transported into the inorganic layer depositing compartment 14; in the inorganic layer depositing compartment 14, a radio-frequency voltage is applied from the radio-frequency power source 44 to the film depositing electrodes 42a to 42d while, at the same time, the feed gas to form the inorganic layer f is supplied from the feed gas supply section 46 through the piping system 47 so that it is released into the spaces S through the plurality of holes formed in the surfaces of the respective film depositing electrodes 42a to 42d.

When electromagnetic waves are radiated around the film depositing electrodes 42a to 42d, a plasma localized in the neighborhood of the film depositing electrodes 42a to 42d is generated in the spaces S, whereupon the feed gas is excited and dissociated to yield a reaction product that serves to form the inorganic layer f. This reaction product accumulates to form the predetermined inorganic layer f on top of the organic layer b on the surface Zf of the substrate Z within the inorganic layer depositing compartment 14.

Then, the substrate roll 20 around which the elongated substrate Z has been wound is rotated clockwise incrementally with a motor, whereupon the elongated substrate Z is delivered continuously and the organic layer b is formed on the surface Zf of the substrate Z as it is wrapped around the first drum 52 in the organic layer depositing compartment 13; subsequently, with the substrate Z being held on the second drum 26 in the position where the plasma is being generated, the second drum 26 is rotated at a predetermined speed to ensure that the film depositing unit 40 allows the inorganic layer f to be formed continuously on top of the organic layer b.

In this way, there is produced a functional film F that has the organic layer b and the inorganic layer f formed in superposition on the surface Zf of the substrate Z. The substrate Z having the organic layer b and the inorganic layer f formed in superposition on its surface Zf passes over the guide rollers 28 and 31 so that the functional film F, or the elongated substrate Z with the deposited layers, is wound up by the takeup troll 30.

This is how the functional film F, or the elongated substrate Z with the organic layer b and the inorganic layer f formed in superposition on its surface Zf, is produced by the method of film deposition using the film depositing apparatus 10 according to the first embodiment.

The film depositing apparatus 10 according to the first embodiment is such that the organic layer b and the inorganic layer f are formed in different film deposition compartments, the first in the organic layer depositing compartment 13 and the second in the inorganic layer depositing compartment 14. As a result, there is no possibility that the organic materials such as monomers that are used to form the organic layer b will get into the inorganic layer depositing compartment 14 to contaminate it, nor is there the possibility that the feed gas supplied into the inorganic layer depositing compartment 14 to form the inorganic layer f or the reaction product and the like that are generated in the film deposition process will get into the organic layer depositing compartment 13 to contaminate it. This contributes to suppressing a possible drop in the film quality of both the organic layer b and the inorganic layer f. As a result, the functional film F to be eventually obtained by the film depositing apparatus 10 in the first embodiment is satisfactory in the film quality of both the organic layer b and the inorganic layer f, so the functional film, if it is a gas barrier film, features good enough gas barrier performance.

As an additional feature, the first drum 52 to form the organic layer b is provided with the first temperature adjusting unit 56 and the second drum 26 to form the inorganic layer f is provided with the second temperature adjusting unit 49; thus, the temperature at which the organic layer b is deposited and the temperature at which the inorganic layer f is deposited can be varied independently of each other without causing any interference. As a result, each of the temperatures at which the organic layer b and the inorganic layer f are to be deposited can be adjusted to an optimum value and this also contributes to suppressing a possible drop in the film quality of both the organic layer b and the inorganic layer f.

In the first embodiment, the inorganic layer f is deposited by plasma-assisted CVD and the rate of film deposition is slower than the rate at which the organic layer b is deposited by flash evaporation. As a result, the speed at which the substrate Z is transported in the film depositing apparatus 10 is limited by the rate at which the inorganic layer f is deposited.

Under the circumstances, it is necessary to increase the production efficiency by suppressing the slower formation of the inorganic layer f from becoming a rate-limiting factor; to this end, the film deposition zone where the inorganic layer f is to be deposited must be enlarged. In the first embodiment of the invention, this is realized by adapting the second drum 26 in the inorganic layer depositing compartment 14 to have a larger diameter d2 than the first drum 52 in the organic layer depositing compartment 13 which has a diameter d1.

A further advantage of the first embodiment is that since the organic layer depositing compartment 13 is a physically different entity from the inorganic layer depositing compartment 14, the diameter d2 of the second drum 26 can be varied independently of the diameter d₁ of the first drum 52.

It should be noted here that the diameter d₁ of the first drum 52 and the diameter d₂ of the second drum 26 may be determined by rates at which the organic layer b and the inorganic layer f are to be deposited.

### SECOND EMBODIMENT

We next describe a second embodiment of the present invention.

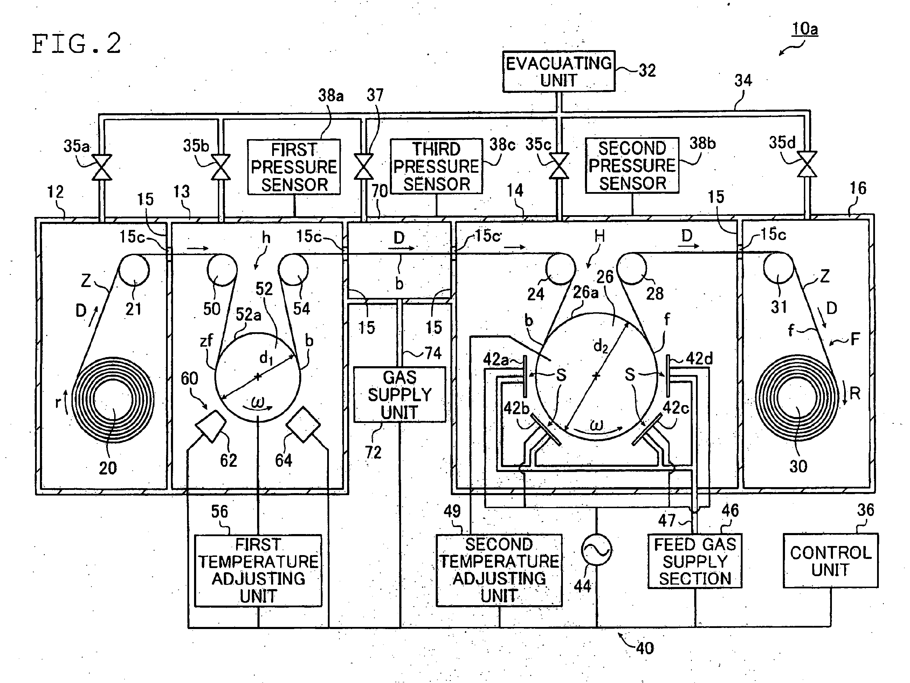

FIG. 2 is a schematic diagram showing a film depositing apparatus according to the second embodiment of the present invention.

In the second embodiment of the present invention, those parts which are identical to the parts of the film depositing apparatus according to the first embodiment shown in FIG. 1 are identified by like numerals and will not be described in detail.

As shown in FIG. 2, the film depositing apparatus according to the second embodiment which is generally indicated by 10a differs from the film depositing apparatus 10 according to the first embodiment (see FIG. 1) in that a differential pressure compartment 70 is provided in the optical path between the organic layer depositing compartment 13 and the inorganic layer depositing compartment 14; since the other structural features of the film depositing apparatus 10a are identical to those of the film depositing apparatus 10 according to the first embodiment, they will not be described in detail.

The differential pressure compartment 70 according to the second embodiment under consideration is a site through which the substrate Z having the organic layer b formed thereon is transported.

The differential pressure compartment 70 is connected to the evacuating unit 32 via the piping system 34, which is fitted with a valve (pressure adjusting means) 37. The valve 37 is structurally the same as the first valve 35a, the second valve 35b, the third valve 35c, and the fourth valve 35d. The valve 37 also has such functions as for releasing the pressure to the atmosphere (venting) and adjusting the volume of evacuation. Again, the valve 37 may be composed of two valves, one capable of releasing the pressure to the atmosphere (venting) and the other for adjusting the volume of evacuation.

In addition, the differential pressure compartment 70 is equipped with a third pressure sensor 38c for measuring the internal pressure. The third pressure sensor 38c is structurally the same as the first pressure sensor 38a and the second pressure sensor 38b.

Further in addition, the differential pressure compartment 70 is connected to a gas supply unit 72 via a pipe 74. The gas supply unit 72 serves to supply gases that cause only small effects on film deposition, as exemplified by inert gases including nitrogen gas and argon gas.

The structure of the gas supply unit 72 is not particularly limited as long as it can supply inert gases into the differential pressure compartment 70 via the pipe 74 at a predetermined pressure and flow rate.

In the film depositing apparatus 10a according to the second embodiment under consideration, the valve 37 may be controlled such that a smaller volume is evacuated through it by the evacuating unit 32 than what is evacuated through the second valve 35b connecting to the organic layer depositing compartment 13 and through the third valve 35c connecting to the inorganic layer depositing compartment 14, whereby the pressure in the differential pressure compartment 70 can be made higher than the pressure in the organic layer depositing compartment 13 and the pressure in the inorganic layer depositing compartment 14.

Alternatively, an inert gas may be supplied from the gas supply unit 72 into the differential pressure compartment 70, whereby the pressure in the differential pressure compartment 70 can be made higher than the pressure in the organic layer depositing compartment 13 and the pressure in the inorganic layer depositing compartment 14 while ensuring that only small effects are exerted on film deposition.

Note that the pressure in the differential pressure compartment 70 may be described as higher than the pressure in the organic layer depositing compartment 13 and the pressure in the inorganic layer depositing compartment 14 if the pressure in the differential pressure compartment 70 is at least 10% higher than the two other pressures. Taking the organic layer depositing compartment 13 as an example, this condition can be expressed mathematically as follows: the pressure (Pa) in the differential pressure compartment 70/the pressure (Pa) in the organic layer depositing compartment 13 ≤ 0.9

If, in the film depositing apparatus 10a according to the second embodiment, the pressure in the differential pressure compartment 70 is controlled to be higher than the pressure in the organic layer depositing compartment 13 and the pressure in the inorganic layer depositing compartment 14, there occur two flows, one coming from the differential pressure compartment 70 into the organic layer depositing compartment 13 and the other coming from the differential pressure compartment 70 into the inorganic layer depositing compartment 14. On account of this pushing action of the differential pressure compartment 70, there is no possibility that the organic materials such as monomers that are used to form the organic layer b will get into the inorganic layer depositing compartment 14 to contaminate it; nor is there the possibility that the feed gas supplied into the inorganic layer depositing compartment 14 to form the inorganic layer f or the reaction product and the like that are generated in the film deposition process will get into the organic layer depositing compartment 13 to contaminate it. As a result, the inorganic layer f can be deposited in an even cleaner environment to produce a functional film F having even more satisfactory performance.

Note that by supplying an inert gas into the differential pressure compartment 70, it is also possible to ensure that only small effects will be exerted on the organic layer b formed.

Concerning the second embodiment, it should also be noted that the pressure in the differential pressure compartment 70 may be lower than the pressure in the organic layer depositing compartment 13 and the pressure in the inorganic layer depositing compartment 14.

In this alternative case, the valve 37 connecting to the differential pressure compartment 70 may be controlled such that a greater volume is evacuated through it by the evacuating unit 32 than what is evacuated through the second valve 35b connecting to the organic layer depositing compartment 13 and through the third valve 35c connecting to the inorganic layer depositing compartment 14, whereby the pressure in the differential pressure compartment 70 can be made lower than the pressure in the organic layer depositing compartment 13 and the pressure in the inorganic layer depositing compartment 14.

Alternatively, an evacuating means (pressure adjusting means) such as a vacuum pump that selectively evacuates the interior of the differential pressure compartment 70 may be provided to make the pressure in the differential pressure compartment 70 lower than the pressure in the organic layer depositing compartment 13 and the pressure in the inorganic layer depositing compartment 14.

If, in the film depositing apparatus 10a according to the second embodiment, the pressure in the differential pressure compartment 70 is controlled to be lower than the pressure in the organic layer depositing compartment 13 and the pressure in the inorganic layer depositing compartment 14, there occur two flows, one coming from the organic layer depositing compartment 13 into the differential pressure compartment 70 and the other coming from the inorganic layer depositing compartment 14 into the differential pressure compartment 70. On account of this sucking action of the differential pressure compartment 70, there is no possibility that the organic materials such as monomers that are used to form the organic layer b will get into the inorganic layer depositing compartment 14 to contaminate it; nor is there the possibility that the feed gas supplied into the inorganic layer depositing compartment 14 to form the inorganic layer f or the reaction product and the like that are generated in the film deposition process will get into the organic layer depositing compartment 13 to contaminate it. As a result, the inorganic layer f can be deposited in an even cleaner environment to produce a functional film F having even more satisfactory performance.

It is worth mention that the film depositing apparatus 10a according to the second embodiment under consideration can provide not only its inherent advantage described above but also the same advantage as achieved by the film depositing apparatus 10 according to the first embodiments.

We next describe how a film is deposited by the film depositing apparatus 10a according to the second embodiment of the present invention.

The only difference between the method of film deposition by the film depositing apparatus 10a according to the second embodiment of the present invention and the method of film deposition by the film depositing apparatus 10 according to the first embodiment is that in the former method, the substrate Z, after the organic layer b is formed on its surface Zf, is passed through the differential pressure compartment 70, thence transported into the inorganic layer depositing compartment 14. The other steps in film deposition are the same as those in the method of film deposition by the film depositing apparatus 10 according to the first embodiment and hence will not be described in detail.

The following description assumes the case where the pressure in the differential pressure compartment 70 is higher than the pressure in the organic layer depositing compartment 13 and the pressure in the inorganic layer depositing compartment 14.

In the method of film deposition according to the second embodiment under consideration, the evacuating unit 32 as well as the first valve 35a, the second valve 35b, the third valve 35c and the fourth valve 35d are so operated that the pressure in the supply compartment 12, the pressure in the organic layer depositing compartment 13, the pressure in the inorganic layer depositing compartment 14 and the pressure in the takeup compartment 16 are adjusted to specified values, which are then maintained. In a separate step, an inert gas is supplied from the gas supply unit 72 into the differential pressure compartment 70 to increase its internal pressure. With the pressure in the differential pressure compartment 70 being elevated, the elongated substrate Z that has been unwound from the substrate roll 20 and transported into the organic layer depositing compartment 13 via the guide roller 21 has the organic layer b formed on its surface Zf by means of the organic layer forming unit 60 in the organic layer depositing compartment 13.

In the next step, the substrate Z, with the organic layer b having been formed on the surface Zf, is transported into the differential pressure compartment 70, thence into the inorganic layer depositing compartment 14. The differential pressure compartment 70, containing the inert gas supplied into its interior, has a higher internal pressure than the pressure in the organic layer depositing compartment 13 and the pressure in the inorganic layer depositing compartment 14.

As a result, there is no possibility that the organic materials such as monomers that are used to form the organic layer b will contaminate the inorganic layer depositing compartment 14 by migrating into it from the organic layer depositing compartment 13 which has a lower internal pressure than the differential pressure compartment 70; nor is there the possibility that the feed gas supplied into the inorganic layer depositing compartment 14 to form the inorganic layer for the reaction product and the like that are generated in the film deposition process will contaminate the organic layer depositing compartment 13 by getting back into it.

In the inorganic layer depositing compartment 14, the feed gas is supplied into the spaces S through the plurality of holes formed in the surfaces of the film depositing electrodes 42a to 42d, whereby a plasma is generated to deposit the inorganic layer f on top of the organic layer b formed on the substrate Z. As mentioned above, there are no chances of any kind of contamination to occur in the process, so the inorganic layer f can be deposited in an even cleaner environment.

The functional film F, or the substrate Z having the organic layer b and the inorganic layer f formed in superposition on its surface Zf, passes over the guide rollers 28 and 31 to be wound up by the takeup roll 30.

The functional film F thus obtained by the film depositing apparatus 10a according to the second embodiment of the present invention is similar to the functional film F produced by the film depositing apparatus 10 according to the first embodiment in that good enough gas barrier performance is assured if it is a gas barrier film.

It should also be mentioned that in the second embodiment under consideration, the pressure in the differential pressure compartment 70 may be rendered lower than the pressure in the organic layer depositing compartment 13 and the pressure in the inorganic layer depositing compartment 14 to form the functional film F, or the substrate Z having the organic layer.b and the inorganic layer f formed in superposition on its surface Zf.

In each of the foregoing embodiments, if a gas barrier film (water vapor barrier film) is to be produced as the functional film, the inorganic layer f to be formed may be exemplified by a silicon nitride film, an aluminum oxide film, or a silicon oxide film.

If protective films for a variety of devices or apparatuses including display devices such as organic EL displays and liquid-crystal displays are to be produced as the functional film, the inorganic layer f to be deposited may be exemplified by a silicon oxide film.

Further in addition, if optical films including an anti-light reflection film, a light reflective film and various other films are to be produced as the functional film, the inorganic layer f to be formed is one having the desired optical characteristics or one comprising materials that exhibit the desired optical characteristics.

It should also be noted that the inorganic layer f to be formed is not limited to a single-layer structure but may be composed of more than one sub-layer. If more than one inorganic layer f is to be formed, the individual layers may be the same or different from each other.

The film depositing apparatuses 10 and 10a according to the first and second embodiments have been described above with reference to the case of adopting plasma-assisted CVD but this is not the only applicable method. The film depositing unit of the present invention may adopt a variety of physical vapor-phase deposition (PVD) techniques, sputtering, evaporation and ion plating as long as they are classified as vapor-phase deposition techniques.

## Claims

1. A film depositing apparatus (10a) by which an organic layer (b) can be formed on a surface (Zf) of an elongated substrate (Z) as it is transported along a predetermined transport path in a longitudinal direction (D) and then an inorganic layer (f) can be formed on top of the organic layer (b), the film depositing apparatus comprising:
a transport means (21, 50, 54, 24, 28, 31) for transporting the substrate (Z) along the predetermined transport path;
a first film deposition compartment (13) that is provided with a first film depositing means (62, 64) for forming the organic layer (b) on the surface (Zf) of the substrate (Z); and
a second film deposition compartment (14) that is disposed downstream of the first film deposition compartment (13) in the transport path and which is provided with a second film depositing means (40) for forming an inorganic layer (f) on top of the organic layer (b), **characterized by**:
a supply compartment (12) for supplying the elongated substrate (Z);
a take-up compartment (16) for winding up the elongated substrate (Z);
a differential pressure compartment (70) disposed in the transport path between the first film deposition compartment (13) and the second film deposition compartment (14); and
an evacuating unit (32) that is arranged to reduce the pressures within the first film deposition compartment (13), the second film deposition compartment (14), the supply compartment (12), the take-up compartment (16) and the differential pressure compartment (70), wherein:
the transport means is arranged such that the substrate (Z) is transported through the first film deposition compartment (13), the differential pressure compartment (70) and the second film deposition compartment (14) in that order.

2. The film depositing apparatus according to claim 1, wherein the first film depositing means (62, 64) forms the organic layer (b) by flash evaporation and the second film depositing means (40) forms the inorganic layer (f) by one of sputtering and plasma-assisted CVD.

3. The film depositing apparatus according to claim 1 or 2, wherein the first film deposition compartment (13) is provided with a rotatable, cylindrical first drum (20) that has an axis of rotation in a direction of width perpendicular to the direction of transport of the substrate (Z) and around which the substrate (Z) transported by the transport means (21, 50, 54, 24, 28, 31) is wrapped, with the organic layer (b) being formed on the surface (f) of the substrate (Z) by the first film depositing means (62, 64) as the substrate (Z) remains wrapped around the first drum (20), and
wherein the second film deposition compartment (14) is provided with a rotatable, cylindrical second drum (30) that has an axis of rotation in a direction of width perpendicular (ω) to the direction of transport (D) of the substrate (Z) and around which the substrate (Z) having the organic layer (b) formed thereon is wrapped, with the inorganic layer (f) being formed on a surface of the organic layer (b) by the second.film depositing means (40) as the substrate (Z) remains wrapped around the second drum (30).

4. The film depositing apparatus according to claim 3, wherein the second drum (30) has a larger diameter than the first drum (20).

5. The film depositing apparatus according to claim 3 or 4, wherein each of the first and second drums (20, 30) is provided with a temperature adjusting means (56, 49) and the first and second drums (20, 30) are controlled in temperature independently of each other.

6. The film depositing apparatus according to claim 1, wherein the pressure in the differential pressure compartment (70) is higher than either of the pressures in the first and second film deposition compartments (13, 14).

7. The film depositing apparatus according to claim 6, further comprising: a gas supply means (46) for supplying an inert gas into the differential pressure compartment (70).

8. The film depositing apparatus according to claim 1, wherein the pressure in the differential pressure compartment (70) is lower than either of the pressures in the first and second film deposition compartments (13, 14).

9. The film depositing apparatus according to claim 8, further comprising: a pressure adjusting means (32) for adjusting the pressure in the differential pressure compartment (70).

## Patentansprüche

1. Filmabscheidungsvorrichtung (10a), durch die eine organische Schicht (b) auf einer Oberfläche (Zf) eines länglichen Substrats (Z) ausgeformt werden kann, während es entlang eines vorbestimmten Transportpfades in Längsrichtung (D) transportiert wird, und dann eine anorganische Schicht (f) auf der organischen Schicht (b) ausgeformt werden kann, wobei die Filmabscheidungsvorrichtung aufweist:
ein Transportmittel (21, 50, 54, 24, 28, 31) zum Transportieren des Substrats (Z) entlang eines vorbestimmten Transportpfades;
ein erstes Filmabscheideabteil (13), das mit einem ersten Filmabscheidungsmittel (62, 64) versehen ist, zum Formen der organischen Schicht (b) auf der Oberfläche (Zf) des Substrats (Z); und
ein zweites Filmabscheideabteil (14), das dem ersten Filmabscheideabteil (13) in dem Transportpfad nachfolgend vorgesehen ist und das mit einem Filmabscheidungsmittel (40) versehen ist, zum Ausformen einer anorganischen Schicht (f) auf der organischen Schicht (b), **gekennzeichnet durch**:
ein Zufuhrabteil (12) zum Zuführen des länglichen Substrats (Z);
ein Aufnahmeabteil (16) zum Aufwickeln des länglichen Substrats (Z);
ein Differenzdruckabteil (70), das im Transportpfad zwischen dem ersten Filmabscheideabteil (13) und dem zweiten Filmabscheideabteil (14) angeordnet ist; und
eine Evakuierungseinheit (32), die dazu angeordnet ist, den Druck in dem ersten Filmabscheideabteil (13), dem zweiten Filmabscheideabteil (14), dem Zufuhrabteil (12), dem Aufnahmeabteil (16) und dem Differenzdruckabteil (70) zu reduzieren, wobei:
das Transportmittel so angeordnet ist, dass das Substrat (Z) **durch** das erste Filmabscheideabteil (13), das Differenzdruckabteil (70) und das zweite Filmabscheideabteil (14) in dieser Reihenfolge transportiert wird.

2. Filmabscheidungsvorrichtung nach Anspruch 1, wobei das erste Filmabscheidungsmittel (62, 64) die organische Schicht (b) durch Entspannungsverdampfung ausformt und das zweite Filmabscheidungsmittel (40) die anorganische Schicht (f) durch Sputtern oder plasmaunterstützte Chemische Gasphasenabscheidung ausformt.

3. Filmabscheidungsvorrichtung nach Anspruch 1 oder 2, wobei das erste Filmabscheideabteil (13) mit einer rotierbaren zylindrischen ersten Trommel (20) versehen ist, die eine Rotationsachse in einer Richtung einer Breite senkrecht zu der Transportrichtung des Substrats (Z) hat und um die das Substrat (Z), das durch das Transportmittel (21, 50, 54, 24, 28, 31) transportiert wird, gewickelt ist, wobei die organische Schicht (b) auf der Oberfläche (f) des Substrats (Z) durch das erste Filmabscheidungsmittel (62, 64) ausgeformt wird, während das Substrat (Z) um die erste Trommel (20) gewickelt bleibt, und
wobei das zweite Filmabscheideabteil (14) mit einer rotierbaren zylindrischen zweiten Trommel (30) versehen ist, die eine Rotationsachse in einer Breitenrichtung senkrecht (ω) zu der Transportrichtung (D) des Substrats (Z) hat und um die das Substrat (Z), das die organische Schicht (b) auf sich ausgeformt hat, gewickelt ist, wobei die anorganische Schicht (f) auf der Oberfläche der organischen Schicht (b) durch das zweite Filmabscheidungsmittel (40) ausgeformt wird, während das Substrat (Z) um die zweite Trommel (30) gewickelt bleibt.

4. Filmabscheidungsvorrichtung nach Anspruch 3, wobei die zweite Trommel (30) einen größeren Durchmesser als die erste Trommel (20) hat.

5. Filmabscheidungsvorrichtung nach Anspruch 3 oder 4, wobei jede der ersten und zweiten Trommeln (20, 30) mit einem temperatureinstellenden Mittel (56, 49) versehen ist und die erste und zweite Trommel (20, 30) unabhängig voneinander temperaturgesteuert sind.

6. Filmabscheidungsvorrichtung nach Anspruch 1, wobei der Druck in dem Differenzdruckabteil (70) größer als einer der Drücke in dem ersten und zweiten Filmabscheideabteil (13, 14) ist.

7. Filmabscheidungsvorrichtung nach Anspruch 6, ferner aufweisend: ein Gaszufuhrmittel (46) zum Zuführen eines inerten Gases in das Differenzdruckabteil (70).

8. Filmabscheidungsvorrichtung nach Anspruch 1, wobei der Druck in dem Differenzdruckabteil (70) kleiner als einer der Drücke in dem ersten und zweiten Filmabscheideabteil (13, 14) ist.

9. Filmabscheidungsvorrichtung nach Anspruch 8, ferner aufweisend: ein Druckanpassungsmittel (32) zum Anpassen des Drucks in dem Differenzdruckabteil (70)

## Revendications

1. Appareil de dépôt de film (10a) par lequel une couche organique (b) peut être formée sur une surface (Zf) d'un substrat allongé (Z) à mesure qu'il est transporté le long d'un trajet de transport prédéterminée dans une direction longitudinale (D) et ensuite une couche inorganique (f) peut être formée au-dessus de la couche organique (b), l'appareil de dépôt de film comprenant :
un moyen de transport (21, 50, 54, 24, 28, 31) pour transporter le substrat (Z) le long du trajet de transport prédéterminé ;
un premier compartiment de dépôt de film (13) qui est pourvu d'un premier moyen de dépôt de film (62, 64) pour former la couche organique (b) sur la surface (Zf) du substrat (Z) ; et
un deuxième compartiment de dépôt de film (14) qui est disposé en aval du premier compartiment de dépôt de film (13) dans le trajet de transport et qui est pourvu d'un deuxième moyen de dépôt film (40) pour former une couche inorganique (f) au-dessus de la couche organique (b), **caractérisé par** :
un compartiment d'alimentation (12) destiné à alimenter le substrat allongé (z) ;
un compartiment d'enroulement (16) destiné à enrouler le substrat allongé (Z) ;
un compartiment de pression différentielle (70) disposé dans le trajet de transport entre le premier compartiment de dépôt de film (13) et le deuxième compartiment de dépôt de film (14) ; et
une unité d'évacuation (32) qui est agencée pour réduire les pressions dans le premier compartiment de dépôt de film (13), le deuxième compartiment de dépôt de film (14), le compartiment d'alimentation (12), le compartiment d'enroulement (16) et le compartiment de pression différentielle (70), où :
le moyen de transport est agencé de sorte que le substrat (Z) soit transporté à travers le premier compartiment de dépôt de film (13), le compartiment de pression différentielle (70) et le deuxième compartiment de dépôt de film (14) dans cet ordre.

2. Appareil de dépôt de film selon la revendication 1, dans lequel le premier moyen de dépôt de film (62, 64) forme la couche organique (b) par évaporation éclair et le deuxième moyen de dépôt de film (40) forme la couche inorganique (f) par pulvérisation cathodique ou dépôt chimique en phase vapeur (CVD) assisté par plasma.

3. Appareil de dépôt de film selon la revendication 1 ou 2, dans lequel le premier compartiment de dépôt de film (13) est pourvu d'un premier tambour rotatif, cylindrique (20) qui présente un axe de rotation dans une direction de largeur perpendiculaire à la direction de transport du substrat (Z) et autour duquel le substrat (Z) transporté par le moyen de transport (21, 50, 54, 24, 28, 31) est enroulé, la couche organique (b) étant formée sur la surface (f) du substrat (Z) par le premier moyen de dépôt de film (62, 64) à mesure que le substrat (Z) reste enroulé autour du premier tambour (20), et
dans lequel le deuxième compartiment de dépôt de film (14) est pourvu d'un deuxième tambour rotatif, cylindrique (30) qui présente un axe de rotation dans une direction de largeur perpendiculaire (ω) à la direction de transport (D) du substrat (Z) et autour duquel le substrat (Z) sur lequel est formée la couche organique (b) est enroulé, la couche inorganique (f) étant formée sur une surface de la couche organique (b) par le deuxième moyen de dépôt de film (40) à mesure que le substrat (Z) reste enroulé autour du deuxième tambour (30).

4. Appareil de dépôt de film selon la revendication 3, dans lequel le deuxième tambour (30) a un diamètre plus grand que celui du premier tambour (20).

5. Appareil de dépôt de film selon la revendication 3 ou 4, dans lequel chacun des premier et deuxième tambours (20, 30) est pourvu d'un moyen de régulation de température (56, 49) et les températures des premier et deuxième tambours (20, 30) sont commandées indépendamment l'un de l'autre.

6. Appareil de dépôt de film selon la revendication 1, dans lequel la pression dans le compartiment de pression différentielle (70) est supérieure à l'une ou l'autre des pressions dans les premier et deuxième compartiments de dépôt de film (13, 14).

7. Appareil de dépôt de film selon la revendication 6, comprenant en outre : un moyen d'alimentation en gaz (46) destiné à alimenter en gaz inerte le compartiment de pression différentielle (70).

8. Appareil de dépôt de film selon la revendication 1, dans lequel la pression dans le compartiment de pression différentielle (70) est inférieure à l'une ou l'autre des pressions dans les premier et deuxième compartiments de dépôt de film (13, 14).

9. Appareil de dépôt de film selon la revendication 8, comprenant en outre : un moyen de régulation de pression (32) destiné à réguler la pression dans le compartiment de pression différentielle (70).
